# EUROPEAN PATENT APPLICATION

(11) **EP 4 345 864 A1**
(43) Date of publication of application: **03.04.2024**
(21) Application number: 21962801.3
(22) Date of filing: 02.11.2021

(54) **LIGHT-EMITTING SUBSTRATE AND DISPLAY DEVICE**

(71) Applicant: BOE Technology Group Co., Ltd., Chaoyang District, Beijing 100015 (CN); Hefei Boe Ruisheng Technology Co., Ltd., Hefei, Anhui 230012 (CN)
(72) Inventor: LEI, Jie, Beijing 100176 (CN); XU, Zouming, Beijing 100176 (CN); TIAN, Jian, Beijing 100176 (CN); LIU, Chunjian, Beijing 100176 (CN); WU, Xintao, Beijing 100176 (CN); WANG, Jie, Beijing 100176 (CN); ZHANG, Jianying, Beijing 100176 (CN); JIN, Zhi, Beijing 100176 (CN)
(74) Representative: Potter Clarkson
(86) International application number: PCT/CN2021/128266
(87) International publication number: WO 2023/077281

(57) **Abstract**

Provided are a light-emitting substrate and a display device, relating to the technical field of display. The light-emitting substrate comprises a plurality of signal channels (CH) arranged in sequence along a row direction (H1). Each signal channel (CH) comprises a plurality of control regions (BB) arranged along a column direction (H2). Each control region (BB) comprises at least one lamp region (AA) controlled by the same chip (IC). In each signal channel (CH), the light-emitting substrate is provided with a first driving wire, a second driving wire and a plurality of reference power lines (GNDA). The first driving wire and the second driving wire are respectively used for providing different driving signals to the chip (IC). The reference power lines (GNDA) are used for providing reference power supply voltages (GND) to the chip (IC). The reference power lines (GNDA) in the same signal channel (CH) are electrically connected, and at least one reference power line (GNDA) is arranged between the first driving wire and the second driving wire. The light-emitting substrate can reduce the noise on at least part of the driving wires.

## Description

### TECHNICAL FIELD

The present disclosure relates to the field of display technology, and in particular, to a light-emitting substrate and a display device.

### BACKGROUND

The LED (Light-Emitting Diode) light-emitting substrate may be driven in an active driving mode, where LEDs and a chip for driving the LEDs are provided in the light-emitting area. An external circuit (such as a circuit board) provides power and signals to the LEDs and the chip through driving lines provided on the light-emitting substrate. When the driving lines are disturbed and generate noise, the luminous quality of the LED light-emitting substrate will be greatly affected.

It should be noted that the information disclosed in the background section is only used to enhance understanding of the background of the present disclosure, and therefore may include information that does not constitute prior art known to those of ordinary skill in the art.

### SUMMARY

The purpose of the present disclosure is to overcome the above-mentioned shortcomings of the prior art, and provide a light-emitting substrate and a display device, for reducing the noise on at least some of the driving lines.

According to a first aspect of the present disclosure, a light-emitting substrate is provided, including a plurality of signal channels arranged in sequence along a row direction. Each of the signal channels includes a plurality of control areas arranged along a column direction. Each of the control areas includes at least one light area controlled by the same chip.

In each of the signal channels, the light-emitting substrate is provided with a first driving line, a second driving line, and a plurality of reference power lines. The first driving line and the second driving line are respectively used for providing different driving signals to the chip. The reference power line is used for providing a reference power supply voltage to the chip. The reference power lines in the same signal channel are electrically connected. At least one reference power line is provided between the first driving line and the second driving line.

In an embodiment of the present disclosure, the first driving line is a clock signal line for providing a clock signal to the chip.

The second driving line is a driving data line for providing a driving data signal to the chip or an address configuration line for providing an address configuration signal to the chip.

In an embodiment of the present disclosure, the second driving line is a driving data line.

In an embodiment of the present disclosure, in the signal channel, the light-emitting substrate further includes: a light area power line for loading a light area power supply voltage to the light area, a chip power line for loading a chip power supply voltage to the chip, and an address configuration line for loading an address configuration signal to the chip.

Along the row direction, the light area power line, the reference power line, the chip power line, the address configuration line, the clock signal line, the reference power line, the driving data line, the reference power line, and the light area power line are arranged in sequence.

In an embodiment of the present disclosure, the reference power line is further provided between the address configuration line and the clock signal line.

In an embodiment of the present disclosure, the light-emitting substrate has a chip pad group for bonding and connecting with the chip, and is provided with a reference power connection line.

The reference power connection line is connected to each reference power line through a via hole, and is electrically connected to the chip pad group.

In an embodiment of the present disclosure, in the signal channel, the plurality of reference power lines include: two main reference power lines located on both sides of the signal channel, and an auxiliary reference power line located between the main reference power lines. The width of the main reference power line is greater than the width of the auxiliary reference power line.

The main reference power line overlaps the light areas, and does not overlap at least some of the chips.

In an embodiment of the present disclosure, in the signal channel, the plurality of reference power lines include a main reference power line and at least one auxiliary reference power line. The main reference power line has the largest width among the reference power lines, and is not adjacent to the driving data line and the clock signal line.

In an embodiment of the present disclosure, the chip is located between the main reference power line and the auxiliary reference power line.

In an embodiment of the present disclosure, in the signal channel, the light-emitting substrate further includes: a light area power line for loading a light area power supply voltage to the light area, and a chip power line for loading a chip power supply voltage to the chip.

The main reference power line is adjacent to the light area power line, and has a width greater than that of the chip power line.

The width of the auxiliary reference power line is smaller than that of the chip power line.

In an embodiment of the present disclosure, the light-emitting substrate further includes: a light area power line for loading a light area power supply voltage to the light area, and a chip power line for loading a chip power supply voltage to the chip. A first capacitor is provided between at least some of the light area power lines and the reference power lines. A second capacitor is provided between at least some of the chip power lines and the reference power lines.

In an embodiment of the present disclosure, among two adjacent signal channels along the row direction, a light area power line in one signal channel is arranged adjacently to a light area power line in the other signal channel. The two adjacent light area power lines are connected to form a merged light area power line. The merged light area power line is used for providing the light area power supply voltage to the light areas in the two signal channels.

3 to 5 first capacitors are provided between any one of the merged light area power lines and the reference power lines.

In an embodiment of the present disclosure, 2 to 4 second capacitors are provided between any one of the chip power lines and the reference power lines.

In an embodiment of the present disclosure, the light-emitting substrate is provided with a temperature sensor, and a temperature sensor power line for loading a temperature sensor power supply voltage to the temperature sensor.

A third capacitor is provided between any one of the temperature sensor power lines and the reference power lines.

In an embodiment of the present disclosure, the light-emitting substrate includes a base substrate, a driving metal layer, a first insulation layer, a wiring metal layer, a second insulation layer, and a device layer that are stacked in sequence.

The driving metal layer is provided with the first driving line, the second driving line, and the reference power lines.

The light area includes a plurality of electrically connected light-emitting elements. The light-emitting elements and the chip are provided on the device layer.

The wiring metal layer is provided with a light-emitting element pad group for bonding the light-emitting elements, a chip pad group for bonding the chip, and a connection line for connecting the light-emitting element pad group and the chip pad group.

In an embodiment of the present disclosure, the wiring metal layer is provided with a reference power resistance-reducing structure corresponding to at least some of the reference power lines. The reference power resistance-reducing structure and the respective reference power line is connected through a via hole.

In an embodiment of the present disclosure, the orthographic projection of the reference power resistance-reducing structure on the base substrate is located within the orthographic projection of the respective reference power line on the base substrate.

In an embodiment of the present disclosure, at least some of the via holes between the reference power resistance-reducing structure and the respective reference power line are arranged around the edge of the reference power resistance-reducing structure.

In an embodiment of the present disclosure, in the signal channel, the plurality of reference power lines have one or two main reference power lines with the largest width. The reference power resistance-reducing structure and the main reference power line are connected.

In an embodiment of the present disclosure, the driving metal layer is provided with a light area power line for loading a light area power supply voltage to the light area. The wiring metal layer is provided with a light area power resistance-reducing structure corresponding to the light area power line. The light area power line and the respective light area power resistance-reducing structure are connected through a via hole.

In an embodiment of the present disclosure, at least some of the via holes between the light area power resistance-reducing structure and the respective light area power line are arranged around the edge of the light area power resistance-reducing structure.

In an embodiment of the present disclosure, the orthographic projection of the light area power resistance-reducing structure on the base substrate coincides with the orthographic projection of the respective light area power line on the base substrate.

In an embodiment of the present disclosure, the driving metal layer is provided with a chip power line for loading a chip power supply voltage to the chip. The wiring metal layer is provided with a chip power resistance-reducing structure corresponding to the chip power line. The chip power resistance-reducing structure and the respective chip power line are connected through a via hole.

In an embodiment of the present disclosure, at least some of the via holes between the chip power resistance-reducing structure and the respective chip power line are arranged in a line along the column direction.

According to a second aspect of the present disclosure, a display device is provided, including the above-mentioned light-emitting substrate.

It should be understood that the foregoing general description and the following detailed description are exemplary and explanatory only, and do not limit the present disclosure.

### BRIEF DESCRIPTION OF THE DRAWINGS

The accompanying drawings, which are incorporated in and constitute a part of this specification, illustrate embodiments consistent with the present disclosure and together with the description, serve to explain the principle of the present disclosure. Obviously, the drawings in the following description are only some embodiments of the present disclosure. For those of ordinary skill in the art, other drawings can be obtained based on these drawings without exerting creative efforts.
FIG. 1 is a schematic pin diagram of a chip in an embodiment of the present disclosure.
FIG. 2 is a schematic diagram illustrating the connection between the chip pad group and the driving line in an embodiment of the present disclosure.
FIG. 3 is a schematic diagram illustrating the connection between the chip pad group and the driving line in an embodiment of the present disclosure.
FIG. 4 is a schematic partial structural diagram of the driving metal layer in a first embodiment of the present disclosure.
FIG. 5 is a schematic partial structural diagram of the wiring metal layer in the first embodiment of the present disclosure.
FIG. 6 is a schematic partial structural diagram of the driving metal layer and the wiring metal layer in the first embodiment of the present disclosure.
FIG. 7 is a schematic partial structural diagram of the driving metal layer, the wiring metal layer, and the via hole provided on the first insulation layer in the first embodiment of the present disclosure.
FIG. 8 is a partial enlarged view around the chip area of FIG. 7.
FIG. 9 is a schematic partial structural diagram of the driving metal layer in a second embodiment of the present disclosure.
FIG. 10 is a partial enlarged view around the chip area of FIG. 9.
FIG. 11 is a schematic partial structural diagram of the wiring metal layer in the second embodiment of the present disclosure.
FIG. 12 is a partial enlarged view around the chip area of FIG. 11.
FIG. 13 is a schematic partial structural diagram around the chip area of the driving metal layer, the wiring metal layer, and the via hole provided on the first insulation layer in the second embodiment of the present disclosure.
FIG. 14 is a schematic partial structural diagram around the chip area of the driving metal layer, the wiring metal layer, and the via hole provided on the first insulation layer in a third embodiment of the present disclosure.
FIG. 15 is a schematic partial structural diagram around the chip area of the driving metal layer, the wiring metal layer, and the via hole provided on the first insulation layer in a fourth embodiment of the present disclosure.
FIG. 16 is a schematic diagram of a via hole and a resistance-reducing structure on the first insulation layer in an embodiment of the present disclosure.
FIG. 17 is a schematic diagram of a via hole and a resistance-reducing structure on the first insulation layer in an embodiment of the present disclosure.
FIG. 18 is a schematic diagram of a via hole and a resistance-reducing structure on the first insulation layer in an embodiment of the present disclosure.
FIG. 19 is a schematic diagram of a via hole and a resistance-reducing structure on the first insulation layer in an embodiment of the present disclosure.
FIG. 20 is a schematic diagram of a via hole and a resistance-reducing structure on the first insulation layer in an embodiment of the present disclosure.
FIG. 21 is a schematic diagram of the film structure on the light-emitting substrate in an embodiment of the present disclosure.

### Reference Numerals:

AA, light area; BB, control area; CH, signal channel; BP, base substrate; Cu1, driving metal layer; Cu2, wiring metal layer; OC1, first insulation layer; OC2, second insulation layer; VLED, light area power supply voltage; GND, reference power supply voltage; VCC, chip power supply voltage; DIS, address configuration signal; DOS, address relay signal; Data, driving data signal; CLK, clock signal; GNDD, reference power pin; VCCD, chip power pin; DISD, address configuration pin; DOSD, address relay pin; DataD, driving data pin; CLKD, clock signal pin; ICA, chip area; VLEDA, light area power line; GNDA, reference power line; VCCA, chip power line; DSA, address configuration line; DataA, driving data line; CLKA, clock signal line; VLEDB, light area power resistance-reducing structure; GNDB, reference power resistance-reducing structure; VCCB, chip power resistance-reducing structure; GNDL, reference power connection line; VCCL, chip power connection line; DISL, address configuration connection line; DOSL, address relay connection line; DataL, driving data connection line; CLKL, clock signal connection line; LEDL, light area connection line; DSC, address configuration transfer structure; GNDE, reference power line extension; VCCAG, chip power line avoidance gap; GNDAG, reference power line avoidance gap; LEDPAD, light-emitting element pad group; LEDPAD1, first light-emitting element pad; LEDPAD2, second light-emitting element pad; ICPAD, chip pad group; Cst1, first capacitor; Cst2, second capacitor; GNDP, reference power pad; VCCP, chip power pad; DISP, address configuration pad; DOSP, address relay pad; DataP, driving data pad; CLKP, clock signal pad; HH, via hole; H1, row direction; H11, preset direction; H2, column direction.

### DETAILED DESCRIPTION OF THE EMBODIMENTS

Example embodiments will now be described more fully with reference to the accompanying drawings. Example embodiments may, however, be embodied in various forms and should not be construed as limited to the embodiments set forth herein. Rather, these embodiments are provided so that the present disclosure will be thorough and complete, and will fully convey the concept of the example embodiments to those skilled in the art. The same reference numerals in the drawings indicate the same or similar structures, and thus their detailed descriptions will be omitted. Furthermore, the drawings are merely schematic illustrations of the present disclosure, and are not necessarily drawn to scale.

Although relative terms, such as "above" and "below", are used in this specification to describe the relative relationship of one component represented by an icon to another component, these terms are used in this specification only for convenience, for example, according to the example directions shown in the drawings. It will be understood that if the device represented by the icon were turned upside down, components described as being "above" would become components as being "below". When a structure is located "on" another structure, it may mean that the structure is integrally formed on the other structure, or that the structure is "directly" placed on the other structure, or that the structure is "indirectly" placed on the other structure through an intermediate structure.

The terms "a", "an", "the", and "at least one" are used to indicate the presence of one or more elements or components/etc. The terms "include" and "have" are used to indicate an open inclusion and means that there may be additional elements or components/etc. in addition to the listed elements or components/etc. The terms "first", "second", "third" etc. are used as labels only, and are not used as any limitation on the number of the associated objects.

In the present disclosure, unless otherwise specified, the width of a line refers to the size of the line in the row direction.

In the present disclosure, unless otherwise specified, when describing the relative positional relationship between two structures, it refers to the positional relationship between the orthographic projections of the two structures on the base substrate. When describing the positional relationship between two structures relative to the base substrate, it refers to the positional relationship between the two structures in the direction perpendicular to the base substrate, that is, the layer relationship between the film layers where the two structures are located.

When describing an overlap between two structures, it means that the two structures are in different film layers, and the orthographic projections of the two structures on the base substrate at least partially overlap. When describing a complete overlap between two structures, it means that the orthographic projection of one structure on the base substrate is completely located within the orthographic projection of the other structure on the base substrate. When describing a non-overlap between two structures, it means that the orthographic projection of one structure on the base substrate goes beyond the orthographic projection of the other structure on the base substrate.

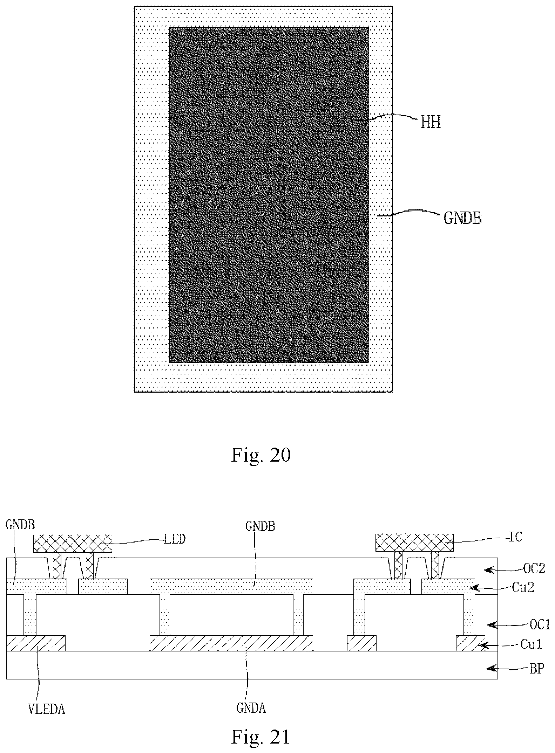

The present disclosure provides a light-emitting substrate and a display device having the light-emitting substrate. Referring to FIG. 21, the light-emitting substrate includes a base substrate BP, a driving metal layer Cu1, a first insulation layer OC1, a wiring metal layer Cu2, a second insulation layer OC2, and a device layer that are stacked in sequence. The driving metal layer Cu1 is formed with a driving line, which is used to electrically connect with external circuits (such as circuit boards) and provide signals and power to electronic components located on the device layer. The wiring metal layer Cu2 is connected to the driving metal layer Cu1 through a via hole. The driving metal layer Cu1 is provided with pads for bonding electronic components and connection lines connected to the pads. At least some of the connection lines are electrically connected to the driving lines to load various electronic components with signals and power (in the present disclosure, the driving lines used to load the power supply voltage may be defined as power lines). The first insulation layer OC1 is used to isolate the driving metal layer Cu1 and the wiring metal layer Cu2, where via holes are provided to electrically connect the driving metal layer Cu1 and the wiring metal layer Cu2. The second insulation layer OC2 is used to protect the wiring metal layer Cu2, and is provided with via holes exposing the pads, so that the electronic components can be bonded and connected to the pads through the via holes.

In the present disclosure, the driving metal layer Cu1 and/or the wiring metal layer Cu2 may also be provided with bonding pads for bonding and connecting with external circuits. The bonding pad may be disposed on the edge of the light-emitting substrate. The light-emitting substrate is provided with a fan-out area at one end close to the bonding pad. The fan-out area is provided with fan-out lines that are electrically connected to the driving lines in a one-to-one correspondence. The fan-out line may be bent to connect onto the corresponding bonding pad. The fan-out lines may be provided in the driving metal layer Cu1 or the wiring metal layer Cu2. Some fan-out lines may also be provided across the driving metal layer Cu1 and the wiring metal layer Cu2. In an embodiment of the present disclosure, the fan-out area may span 2 to 4 rows of light areas, for example, span three rows of light areas.

In the present disclosure, the extending direction of the driving line in the non-fan-out area may be defined as the column direction H2, and the direction perpendicular to the column direction H2 and parallel to the plane where the light-emitting substrate is located may be defined as the row direction H1. In some embodiments of the present disclosure, the fan-out area and the bonding pad are located at one end of the light-emitting substrate along the column direction H2. Further, at the end of the light-emitting substrate away from the fan-out area, at least some of the driving lines (i.e., power lines) loaded with the same power source may be electrically connected to each other. It can be understood that at an end of the light-emitting substrate, the same power lines may be electrically connected either through the conductive structure located in the driving metal layer Cu 1 or through the conductive structure located in the wiring metal layer Cu2, or through both the conductive structures in the driving metal layer Cu1 and the wiring metal layer Cu2. The present disclosure does not impose any special limitation in this regard.

For example, in an embodiment of the present disclosure, the power lines may include a reference power line GNDA for loading the reference power supply voltage GND, and a light area power line VLEDA for loading the light area power supply voltage VLED. At the end away from the fan-out area, the reference power lines GNDA are electrically connected through conductive lines located in the driving metal layer Cu1 and/or the wiring metal layer Cu2, and the light area power lines VLEDA are electrically connected through conductive lines located in the driving metal layer Cu1 and/or the wiring metal layer Cu2.

It is noted that in other embodiments of the present disclosure, both ends of the light-emitting substrate in the column direction H2 may be provided with bonding pads and fan-out areas adjacent to the bonding pads. An external circuit for driving the light-emitting substrate may be electrically connected to the bonding pads at either end to drive the light-emitting substrate.

In the following, each film layer of the light-emitting substrate in the present disclosure is exemplarily introduced and explained from the perspective of the material of each film layer.

In the present disclosure, the base substrate BP may be a base substrate BP of inorganic material or a base substrate BP of organic material. For example, in an embodiment of the present disclosure, the material of the base substrate BP may be soda-lime glass, quartz glass, sapphire glass, and other glass materials. That is, the base substrate BP may be a glass substrate. In another embodiment of the present disclosure, the material of the base substrate BP may be polymethyl methacrylate (PMMA), polyvinyl alcohol (PVA), polyvinyl phenol (PVP), polyether sulfone (PES), polyimide, polyamide, polyacetal, polycarbonate (PC), polyethylene terephthalate (PET), polyethylene naphthalate (PEN), or a combination thereof. That is, the base substrate BP may be an organic flexible substrate. It is noted that in other embodiments of the present disclosure, the base substrate BP may also be made of other materials and structures, such as a multi-layer composite base substrate BP, as long as it can effectively support the light-emitting substrate.

In some embodiments, the thickness of the driving metal layer Cu1 may be greater than the thickness of the wiring metal layer Cu2, so as to reduce the impedance of each driving line, reduce the power consumption of the light-emitting substrate, reduce the difficulty in debugging the light-emitting substrate, and improve the light emission uniformity of the light-emitting substrate. Alternatively, copper electroplating, chemical copper plating, stacking of multiple thin metal layers, or other feasible methods may be used for preparation, so that the driving metal layer Cu1 has a thickness required to meet the electrical performance of the light-emitting substrate. Any thin metal layer may be prepared by magnetron sputtering. The wiring metal layer Cu2 may be prepared by magnetron sputtering. In an embodiment of the present disclosure, the thickness of the driving metal layer Cu1 may be between 1 and 20 microns, for example, between 2 and 5 microns. In an embodiment of the present disclosure, the thickness of the wiring metal layer Cu2 is between 0.3 and 0.8 microns, for example, between 0.3 and 0.5 microns. It is noted that in other embodiments of the present disclosure, the thickness of the driving metal layer Cu1 and the thickness of the wiring metal layer Cu2 may not differ too much, so that they can meet the electrical performance requirements of the light-emitting substrate for the driving lines.

Alternatively, the driving metal layer Cu1 may include one or more stacked metal layers. In an embodiment of the present disclosure, the driving metal layer Cu1 includes at least one copper metal layer, so as to improve the electrical conductivity of the driving metal layer Cu1 and reduce the sheet resistance of the driving metal layer Cu1. Further, the driving metal layer Cu1 may also include other metal layers, for example, an alloy layer (such as molybdenum-niobium alloy) located on the copper metal layer (the side away from the base substrate BP) or below the copper metal layer (the side close to the base substrate BP).

In an embodiment of the present disclosure, the driving metal layer Cu1 may be formed on the base substrate BP through a photolithography process, including sputtering, cleaning, coating, baking, photo exposure, development, hard baking, etching, stripping, and other steps.

In some embodiments, a first passivation layer may also be provided on the upper surface of the driving metal layer Cu1 (the surface away from the base substrate BP). The first passivation layer is used to protect the driving metal layer Cu1 from being oxidized during the processing procedure. The material of the first passivation layer may be inorganic insulation materials such as silicon nitride, silicon oxide, silicon nitride oxide, etc., especially silicon nitride.

The first insulation layer OC1 is disposed on a side of the driving metal layer Cu1 away from the base substrate BP. In some embodiments, the material of the first insulation layer OC1 may be organic materials such as photosensitive resin. The first insulation layer OC1 may be formed through processes including coating, photo exposure, and development, so that the first insulation layer OC1 covers the driving metal layer Cu1, and a via hole is formed to expose part of the driving metal layer Cu1. When the light-emitting substrate is provided with the first passivation layer, the first insulation layer OC1 is formed on a side of the first passivation layer away from the base substrate BP. After the via hole is formed in the first insulation layer OC1, the first insulation layer OC1 may be used as a mask to open a via hole exposing the driving metal layer Cu1 on the first passivation layer.

In the present disclosure, the wiring metal layer Cu2 may include one or more laminated metal layers. In an embodiment of the present disclosure, the wiring metal layer Cu2 includes at least one copper metal layer, so as to improve the electrical conductivity of the wiring metal layer Cu2 and reduce the sheet resistance of the wiring metal layer Cu2. Further, the wiring metal layer Cu2 may also include other metal layers, for example, an alloy layer (such as molybdenum-niobium alloy) located on the copper metal layer (the side away from the base substrate BP) or below the copper metal layer (the side close to the base substrate BP).

In an embodiment of the present disclosure, the wiring metal layer Cu2 may be formed on the base substrate BP through a photolithography process, including sputtering, cleaning, coating, baking, photo exposure, development, hard baking, etching, stripping, and other steps.

In some embodiments, a second passivation layer may also be provided on the upper surface of the wiring metal layer Cu2 (the surface away from the base substrate BP). The second passivation layer is used to protect the wiring metal layer Cu2 and avoid the wiring metal layer Cu2 from being oxidized during the preparation process of the light-emitting substrate. The material of the second passivation layer may be inorganic insulation materials such as silicon nitride, silicon oxide, silicon nitride oxide, etc., especially silicon nitride.

The second insulation layer OC2 is disposed on the side of the wiring metal layer Cu2 away from the base substrate BP. In some embodiments, the material of the second insulation layer OC2 may be organic materials such as photosensitive resin. The second insulation layer OC2 may be formed through a process including coating, photo exposure, and development, so that the second insulation layer OC2 covers the wiring metal layer Cu2 and a via hole is formed exposing part of the wiring metal layer Cu2. When the light-emitting substrate is provided with the second passivation layer, the second insulation layer OC2 is formed on a side of the second passivation layer away from the base substrate BP. After the via hole is formed in the second insulation layer OC2, the second insulation layer OC2 may be used as a mask to open a via hole exposing the pad on the second passivation layer.

It can be understood that in other embodiments of the present disclosure, the materials, film structures, and formation methods of the driving metal layer Cu1 and the wiring metal layer Cu2 may also be other feasible ways, as long as the driving metal layer Cu1 and the wiring metal layer Cu2 that meet the electrical requirements of the light-emitting substrate can be formed. Accordingly, the materials and formation methods of the first insulation layer OC1 and the second insulation layer OC2 may also be other feasible methods.

In the present disclosure, the device layer may include various electronic components bonded and connected to the wiring metal layer Cu2. These electronic components may include light-emitting elements and chip ICs that drive the light-emitting elements. Accordingly, the pads on the wiring metal layer Cu2 include the light-emitting element pad group LEDPAD for bonding with the light-emitting elements and the chip pad group ICPAD for bonding with the chip IC. In some embodiments, the electronic components may further include a temperature sensor, and the wiring metal layer Cu2 may further include a temperature sensor pad group for bonding with the temperature sensor. In some embodiments, the electronic components may further include a capacitor, and the wiring metal layer Cu2 may also be provided with a capacitor pad group for bonding and connecting with the capacitor. In some embodiments, the light-emitting element may be an electronic element that actively emits light, such as Light Emitting Diode (LED), Mini Light Emitting Diode (Mini LED), Micro Light Emitting Diode (Micro LED), etc. The drawings of the present disclosure are all represented and schematically represented by LEDs.

In an embodiment of the present disclosure, the light-emitting element is a Mini LED. The cross-sectional size of the Mini LED (parameters such as length, width, diagonal, or diameter) is between about 100 µm and about 300 µm.

In another embodiment of the present disclosure, the light-emitting element is a Micro LED. The cross-sectional size of the Micro LED (parameters such as length, width, diagonal, or diameter) is below 100 µm.

It can be understood that in other embodiments of the present disclosure, the device layer may also include more types of electronic components, and the wiring metal layer Cu2 may be provided with corresponding pads according to the types and positions of the electronic components.

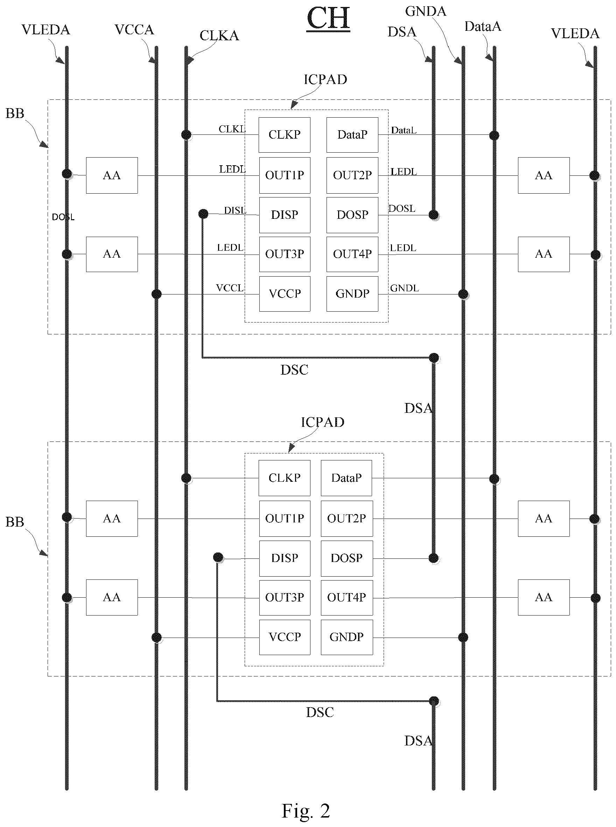

From a top view, referring to FIG. 2, the light-emitting substrate of the present disclosure may include multiple signal channels CH arranged sequentially along the row direction H1 (FIG. 2 shows a partial schematic diagram of a signal channel CH). Each signal channel CH includes a plurality of control areas BB arranged along the column direction H2. Each control area BB includes at least one light area AA controlled by the same chip IC (the chip pad group ICPAD used to bond the chip IC is shown in FIG. 2). In an embodiment of the present disclosure, each control area BB includes multiple light areas AA controlled by the same chip IC, for example, four light areas AA. Each light area AA includes one or more electrically connected light-emitting elements. In an embodiment of the present disclosure, each light area AA includes a plurality of electrically connected light-emitting elements, for example, four light-emitting elements connected in series. It can be understood that in a light area AA, the number of light-emitting elements may be other than four, such as two, six, nine, etc., and the light-emitting elements in the light area AA may be connected in parallel or in series. The present disclosure does not place any special restriction in this regard, as long as each light-emitting element in the light area AA can work synchronously.

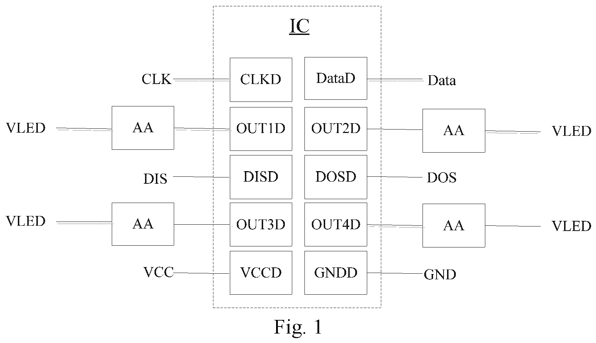

FIG. 1 shows a schematic principle diagram of a chip IC driving four light areas AA simultaneously in an embodiment of the present disclosure. Referring to FIG. 1, the chip IC includes ten pins including four output pins (i.e., the first output pin OUT1D, the second output pin OUT2D, the third output pin OUT3D, and the fourth output pin OUT4D), the clock signal pin CLKD, and the reference power pin GNDD, the driving data pin DataD, the chip power pin VCCD, the address relay pin DOSD, and the address configuration pin DISD. The first output pin OUT1D, the second output pin OUT2D, the third output pin OUT3D, and the fourth output pin OUT4D are respectively electrically connected to the second end of a light area AA. The first end of the light area AA is loaded with the light area power supply voltage VLED. The reference power pin GNDD is used to load the reference power supply voltage GND to the chip IC, the clock signal pin CLKD is used to load the clock signal CLK to the chip IC, the driving data pin DataD is used to load the driving data signal Data to the chip IC, the chip power pin VCCD is used to load the chip power supply voltage VCC to the chip IC, the address configuration pin DISD is used to load the address configuration signal DIS to the chip IC, and the chip IC outputs the address relay signal DOS through the address relay pin DOSD.

FIG. 1 shows the arrangement of pins of a chip IC in an embodiment of the present disclosure. Referring to FIG. 1, pins of the chip IC is arranged in two columns, each column including 5 pins. Each column has two output pins. In an embodiment of the present disclosure, the first column of pins includes the clock signal pin CLKD, the first output pin OUT1D, the address configuration pin DISD, the third output pin OUT3D, and the chip power pin VCCD arranged in sequence. The second column of pins includes the driving data pin DataD, the second output pin OUT2D, the address relay pin DOSD, the fourth output pin OUT4D, and the reference power pin GNDD arranged in sequence. It can be understood that in other embodiments of the present disclosure, the various pins of the chip IC may also be arranged in other ways. For example, the order of the individual pins in each column of pins is adjusted, or each pin is re-arranged in two columns, or the pins may be arranged into three or four columns, etc., so that the chip IC includes the above ten pins.

Referring to FIG. 2, in the same signal channel CH, the chips IC (the chip pad group ICPAD used to bond the chips IC is shown in FIG. 2) may be cascaded in sequence. In two adjacent cascaded chip ICs, the address relay pin DOSD of the chip IC in a previous stage may be electrically connected to the address configuration pin DISD of the chip IC in a subsequent stage, so that the address relay signal DOS of the chip IC in the previous stage serves as the address configuration signal DIS of the chip IC in the subsequent stage. Each chip IC is arranged in a one-to-one correspondence with a respective control area BB. Each control area BB includes four light areas AA, and the four light areas AA are driven by the chip IC corresponding to the control area BB. The chip IC may be located in the corresponding control area BB, or may be located outside the corresponding control area BB, as long as it can drive the four light areas AA in the control area BB.

When the chip IC of the present disclosure is working, it may work in the address configuration mode, the driving configuration mode, and the device driving mode. In the address configuration mode, the external circuit may load the address configuration signal DIS to the address configuration pad DISP of the chip IC, the chip IC may configure its own address according to the received address configuration signal DIS, and automatically generate the address relay signal DOS and output it via the address relay pad DOSP. The address relay signal DOS output by the chip IC may be used as the address configuration signal DIS in the subsequent stage, allowing the chip IC in the subsequent stage to perform address configuration. In this way, the chips IC in a signal channel CH can complete address configuration in sequence and determine their own address information. The address relay signal DOS output by the chip IC in the last stage may be fed back to the external circuit. In the driving configuration mode, the external circuit sends the driving data signal Data and the clock signal CLK to each chip IC in the same signal channel CH. Specifically, the external circuit loads the clock signal CLK to the clock signal pad CLKP of the chip IC, and loads the driving data signal Data to the driving data pad DataP of the chip IC. The clock signal CLK is used to control the chip IC to sample the driving data signal Data, for example, so that the driving data pad DataP is sampled on the rising edge or falling edge of the clock signal CLK. The driving data signal Data contains the driving data information of each chip IC, and each driving data information corresponds to an address information (for example, the driving data information has an address information tag). Each chip IC may receive the driving data information it needs based on its own address information. In the device driving mode, the chip IC may control the on or off of each output pin according to the received driving data information, thereby controlling each light area.

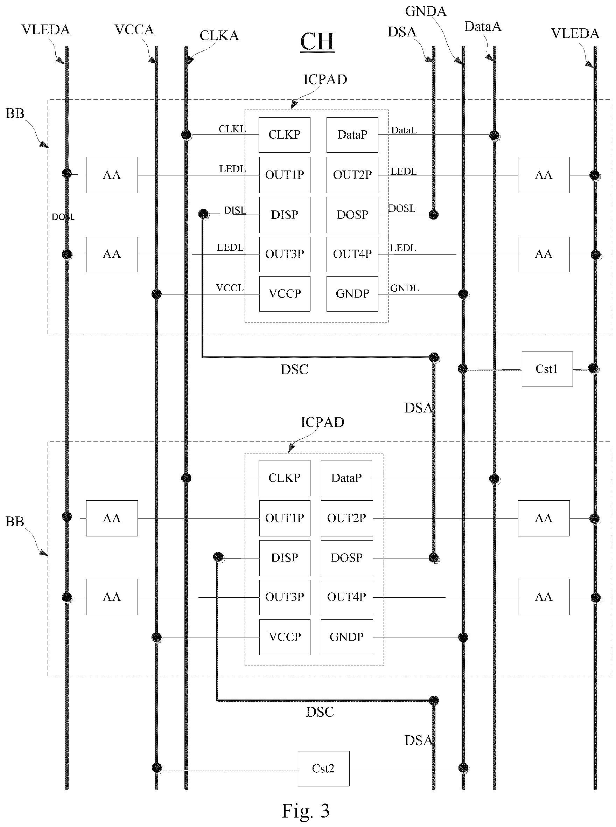

FIGS. 2 and 3 show a schematic principle diagram of a light-emitting substrate in a signal channel CH in some embodiments of the present disclosure. In FIGS. 2 and 3, a chip pad group ICPAD for bonding and connecting with a chip IC is shown. In FIGS. 2 and 3, the order of the driving lines is only a schematic illustration, and does not mean that the driving lines of the light-emitting substrate in the present disclosure are arranged in the order shown in FIGS. 2 and 3.

Referring to FIG. 2, the driving metal layer Cu1 is provided with driving lines. These driving lines include: the reference power line GNDA used to load the reference power supply voltage GND, the light area power line VLEDA used to load the light area power supply voltage VLED, the chip power line VCCA used to load the chip power supply voltage VCC, the address configuration line DSA used to load the address configuration signal DIS, the driving data line DataA used to load the driving data signal Data, and the clock signal line CLKA used to load the clock signal CLK.

The chip pad group ICPAD used for bonding and connecting with the chip IC is provided on the wiring metal layer Cu2. The chip pad group ICPAD includes: the reference power pad GNDP for bonding and connecting with the reference power pin GNDD, the chip power pad VCCP for bonding and connecting with the chip power pin VCCD, the driving data pad DataP for bonding and connecting with the driving data pin DataD, the clock signal pad CLKP for bonding and connecting with the clock signal pin CLKD, the address configuration pad DISP for bonding and connecting with the address configuration pin DISD, the address relay pad DOSP for bonding and connecting with the address relay pin DOSD, and the four output pads each being bonded and connected to a respective one of the four output pins. The four output pads include ten pads such as a first output pad OUT1P for bonding and connecting with the first output pin OUT1D, a second output pad OUT2P for bonding and connecting with the second output pin OUT2D, a third output pad OUT3P for bonding and connecting with the third output pin OUT3D, and a fourth output pad OUT4P for bonding and connecting with the fourth output pin OUT4D.

The arrangement of various pads of the chip pad group ICPAD may match the arrangement of the pins of the chip IC, so that each pin of the chip IC can be bonded to a respective pad in a one-to-one correspondence. In an embodiment of the present disclosure, referring to FIG. 2, in a chip pad group ICPAD, ten pads are arranged in two columns. The first column of pads includes the clock signal pad CLKP, the first output pad OUT1P, the address configuration pad DISP, the third output pad OUT3P, and the chip power pad VCCP arranged in sequence. The second column of pads includes the driving data pad DataP, the second output pad OUT2P, the address relay pad DOSP, the fourth output pad OUT4P, and the reference power pad GNDP arranged in sequence.

In an embodiment of the present disclosure, referring to FIG. 2 and FIG. 3, the chip power pad VCCP and the driving data pad DataP are respectively provided in two columns of pads of the chip pad group ICPAD. One column of pads provided with the chip power pad VCCP is the first column of pads, and one column of pads provided with the driving data pad DataP is the second column of pads. When arranging the chip pad group ICPAD, each column of pads may extend along the column direction H2. In this way, along the row direction H1, the chip power pad VCCP is located on one side of the driving data pad DataP. In the present disclosure, one specific direction among various row directions H1 may be defined as the preset direction H 11, so that the driving data pad DataP is located on a side in the preset direction H11 of the chip power pad VCCP.

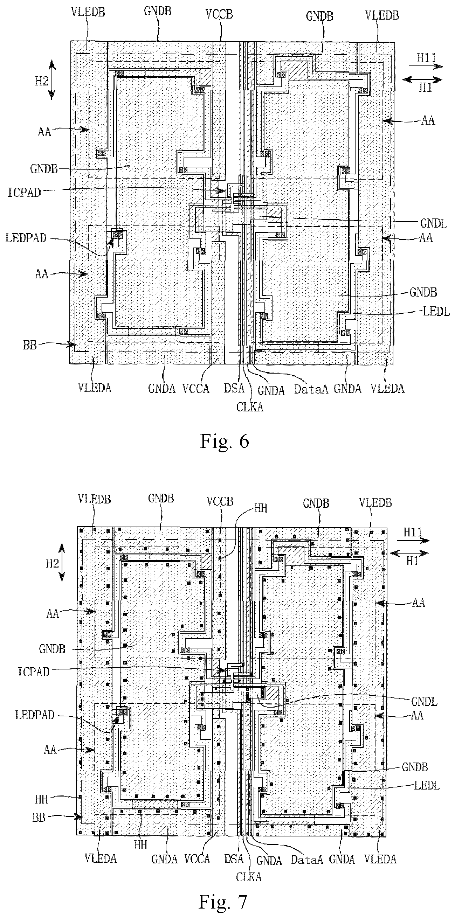

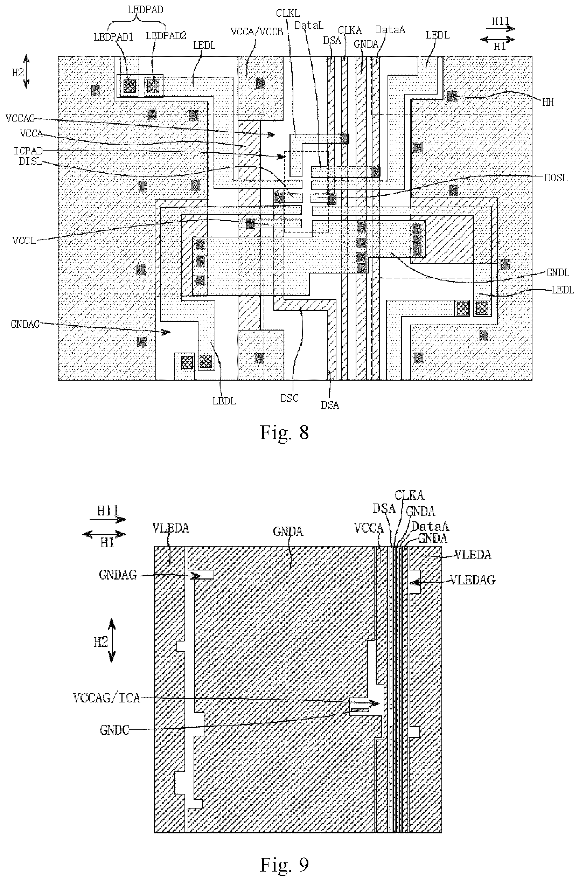

Referring to FIGS. 7 and 8, the wiring metal layer Cu2 is also provided with a light-emitting element pad group LEDPAD for bonding the light-emitting elements. The light-emitting element pad group LEDPAD may include a first light-emitting element pad LEDPAD1 for connecting to the anode of the light-emitting element and a second light-emitting element pad LEDPAD2 for connecting to the cathode of the light-emitting element.

The wiring metal layer Cu2 may also be provided with connection lines, and the connection lines may be connected to the light-emitting element pad group LEDPAD and the chip pad group ICPAD.

The connection lines may include a light area connection line LEDL that is electrically connected to the light-emitting element pad group LEDPAD. The light-emitting element pad groups LEDPAD in the same light area AA are electrically connected through the light area connection line LEDL, so that the light-emitting elements in the same light area AA are electrically connected. The second light-emitting element pad LEDPAD2 in the light area AA may be used as the second end of the light area AA and connected to an output pad (any one of the first output pad OUT 1P, the second output pad OUT2P, the third output pad OUT3P, and the fourth output pad OUT4P) through the light area connection line LEDL. The first light-emitting element pad LEDPAD1 in the light area AA may be used as the first end of the light area AA and connected to the light area power line VLEDA through the light area connection line LEDL.

The connection lines also includes the reference power connection line GNDL, the chip power connection line VCCL, the driving data connection line DataL, the address configuration connection line DISL, the address relay connection line DOSL, the clock signal connection line CLKL, etc. The reference power pad GNDP is electrically connected to the reference power line GNDA through the reference power connection line GNDL. The chip power pad VCCP is electrically connected to the chip power line VCCA through the chip power connection line VCCL. The driving data pad DataP is electrically connected to the driving data line DataA through the driving data connection line DataL. The address configuration pad DISP is connected to the address configuration line DSA through the address configuration connection line DISL. The address relay pad DOSP is connected to the address configuration line DSA through the address relay connection line DOSL. The clock signal pad CLKP is connected to the clock signal line CLKA through the clock signal connection line CLKL.

Referring to FIG. 2, a chip pad group ICPAD is electrically connected to two address configuration lines DSA. The address configuration line DSA electrically connected to the address configuration pad DISP may be defined as the front address configuration line DSA of the chip pad group ICPAD. The address configuration line DSA electrically connected to the address relay pad DOSP may be defined as the rear address configuration line DSA of the chip pad group ICPAD. It can be understood that, among two cascaded chips ICs, the rear address configuration line DSA of the chip pad group ICPAD corresponding to the chip IC in the previous stage is the same address configuration line DSA as the rear address configuration line DSA of the chip pad group ICPAD corresponding to the chip IC in the subsequent stage.

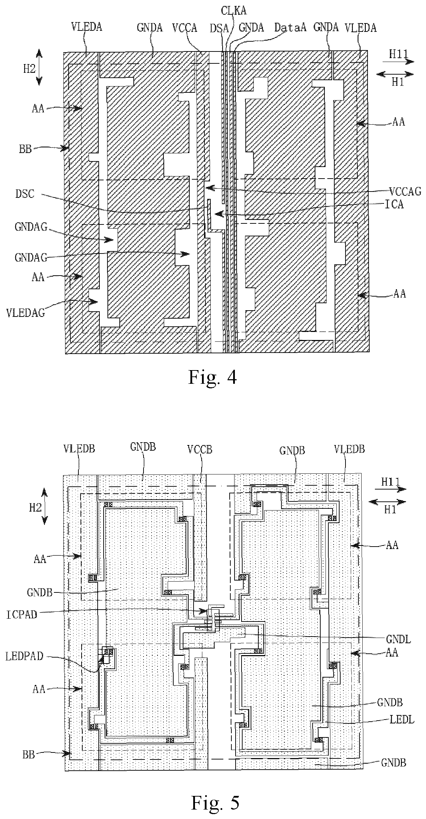

Referring to FIGS. 4, 9, 14 and 15, in some embodiments of the present disclosure, in each signal channel CH of the light-emitting substrate, there are multiple driving lines for loading different driving signals (non-power signals) to the chip . For example, there are the first driving line and the second driving line provided for loading different driving signals. Multiple reference power lines GNDA are also provided in each signal channel CH. The reference power lines GNDA in the same signal channel CH are electrically connected to each other, and at least one reference power line GNDA is provided between the first driving line and the second driving line. In this way, the first driving line and the second driving line may be shielded by the reference power line GNDA to avoid mutual interferences between different driving signals loaded on different driving lines, thereby reducing noises on at least some of the driving lines.

In some examples, the first driving line is the clock signal line CLKA, and the second driving line is the driving data line DataA or the address configuration line DSA.

For example, in an embodiment of the present disclosure, the first driving line is the clock signal line CLKA, and the second driving line is the driving data line DataA. In this way, the light-emitting substrate of the present disclosure can reduce or eliminate the interferences of the driving data signal Data loaded on the driving data line DataA onto the clock signal CLK loaded on the clock signal line CLKA, by setting the reference power line GNDA between the driving data line DataA and the clock signal line CLKA. Thus, the defect is avoided that the clock signal CLK is easily interfered as a high-frequency signal, thereby making the working state of the chip IC to be more stable. Additionally, in each signal channel CH, the reference power lines GNDA are electrically connected to each other, which allows the currents on the reference power lines GNDA to be in communication with each other. This can smooth the current fluctuations on a single reference power line GNDA, thereby making the reference power supply voltage GND to be more stable, and reducing the noise of the reference power supply voltage GND. On the other hand, this can reduce the overall impedance of the reference power line GNDA in the signal channel CH, further improving the signal stability of the reference power supply voltage GND in the signal channel CH.

In an embodiment of the present disclosure, in the same signal channel CH, each reference power line GNDA and the reference power pad GNDP are electrically connected through a reference power connection line GNDL.

In an embodiment of the present disclosure, referring to FIGS. 7 and 8, the chip pad group ICPAD corresponding to at least some of the chips IC is disposed in the control area BB corresponding to the chip IC. A reference power connection line GNDL is provided in the control area BB, and the reference power connection line GNDL is electrically connected to the reference power pad GNDP and each reference power line GNDA. In this way, the reference power supply voltage GND in the signal channel CH can be gridded, further improving the stability of the light-emitting substrate.

In some embodiments of the present disclosure, in a signal channel CH, the sizes of the multiple reference power lines GNDA are not exactly the same. The reference power line GNDA with a larger width may be called the main reference power line GNDA. The reference power line GNDA with a smaller width and mainly used to shield the clock signal line CLKA, the driving data line DataA and other driving lines may be called the auxiliary reference power line GNDA. In an embodiment of the present disclosure, the width of the main reference power line GNDA is greater than the width of the chip power line VCCA, and the width of the chip power line VCCA is greater than the width of each auxiliary reference power line GNDA. In an embodiment of the present disclosure, the main reference power line GNDA may be disposed adjacent to the light area power line VLEDA. It is noted that when two light area power lines VLEDA and one main reference power line GNDA are arranged in the signal channel CH, the main reference power line GNDA is arranged to be adjacent to one of the light area power lines VLEDA, and the other light area power line VLEDA may be adjacent to the auxiliary reference power line GNDA, or may not be adjacent to the reference power line GNDA.

In an embodiment of the present disclosure, the main reference power line GNDA may overlap with the light area AA, and not overlap with at least part of the chip IC.

In some embodiments of the present disclosure, see FIG. 4, in a signal channel CH, along the preset direction H11, the driving lines include the light area power line VLEDA, the reference power line GNDA, the chip power line VCCA, the address configuration line DSA, the clock signal line CLKA, the reference power line GNDA, the driving data line DataA, the reference power line GNDA, and the light area power line VLEDA that are arranged in sequence. Each driving line extends along the column direction H2 as a whole. In an embodiment, the two reference power lines GNDA on both sides of the signal channel CH are the main reference power line GNDAs, and the main reference power lines GNDA are mainly used to load the reference power supply voltages GND to the chip IC. The reference power line GNDA between the two main reference power lines GNDA is the auxiliary reference power line GNDA. The auxiliary reference power line GNDA is set adjacent to the clock signal line CLKA to prevent the crosstalk from signals on other driving lines to the clock signal line CLKA. Referring to FIG. 4, the width of the main reference power line GNDA is greater than the width of the auxiliary reference power line GNDA. In an embodiment of the present disclosure, the chip pad group ICPAD is disposed between the two main reference power lines GNDA, so that the chip pad group ICPAD is close to the center of the signal channel in the row direction.

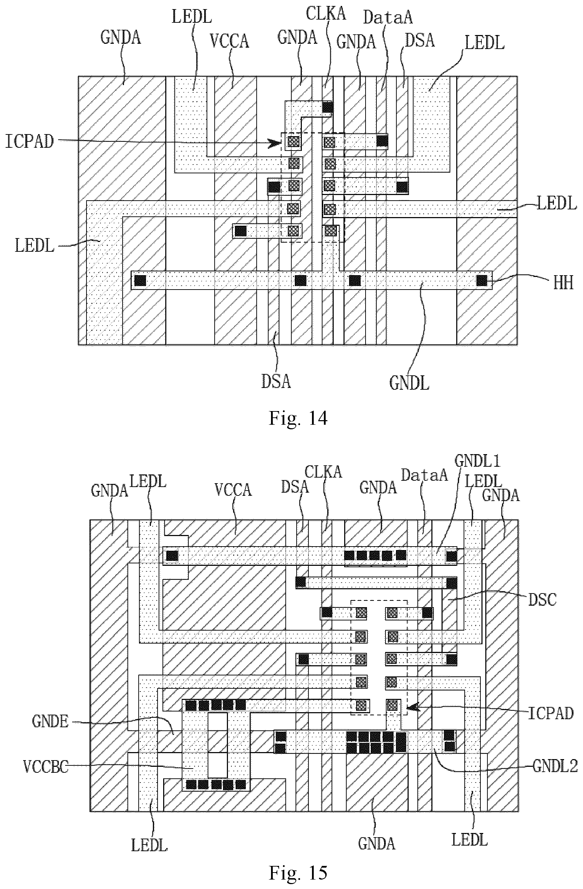

In another embodiment of the present disclosure, referring to FIG. 14, an auxiliary reference power line GNDA may be additionally provided between the address configuration line DSA and the clock signal line CLKA. In this way, the clock signal line CLKA is sandwiched between the two auxiliary reference power lines GNDA, and is less susceptible to the crosstalk from other signals.

In some embodiments of the present disclosure, referring to FIGS. 2, 4 to 8, the light-emitting substrate has a chip area ICA for laying out the chip pad group ICPAD, and the chip pad group ICPAD is laid out in the chip area ICA. In a chip pad group ICPAD, compared to the address relay pad DOSP, the address configuration pad DISP is arranged closer to the chip power line VCCA. The chip pad group ICPAD is located between the chip power line VCCA and the address configuration line DSA. The driving metal layer Cu1 is provided with an address configuration transfer structure DSC on the side of the chip pad group ICPAD close to the chip power line VCCA. The address configuration transfer structure DSC is electrically connected to the front address configuration line DSA of the chip pad group ICPAD. In this way, the address relay pad DOSP of the chip pad group ICPAD can be electrically connected to the rear address configuration line DSA of the chip pad group ICPAD through the address relay connection line DOSL. The address configuration pad DISP of the chip pad group ICPAD may be electrically connected to the DAC through the address configuration connection line DISL, and then electrically connected to the front address configuration line DSA of the chip pad group ICPAD. In some embodiments of the present disclosure, referring to FIG. 4, the chip power line VCCA is provided with a chip power line avoidance gap VCCAG. The address configuration transfer structure DSC is partially set at the chip power line avoidance gap VCCAG. In this way, the chip power line VCCA can avoid the address configuration transfer structure DSC through the chip power line avoidance gap VCCAG, thereby saving space and increasing the width of the driving line.

In an embodiment of the present disclosure, referring to FIG. 4, the part of the chip power line VCCA provided with the chip power line avoidance gap VCCAG is the avoidance section of the chip power line VCCA, and the part of the chip power line VCCA not provided with the chip power line avoidance gap VCCAG is the wiring section of the chip power line VCCA. Due to the setting of the chip power line avoidance gap VCCAG, the width of the avoidance section of the chip power line VCCA is smaller than the width of the wiring section of the chip power line VCCA. Further, edges of the avoidance section and the wiring section of the chip power line VCCA away from the chip pad group ICPAD are the same edge. In other words, by providing the chip power line avoidance gap VCCAG, the chip power line VCCA can avoid the address configuration transfer structure DSC, without the need to bend for avoiding the address configuration transfer structure DSC, thus avoiding the influences of bending on each driving line.

In some embodiments of the present disclosure, referring to FIG. 5 and FIG. 6, part of the reference power line GNDA is provided with a reference power line avoidance gap GNDAG to avoid the light-emitting element pad group LEDPAD. For example, the main reference power line GNDA is provided with a reference power line avoidance gap GNDAG. In this way, the overlap between the light-emitting element pad group LEDPAD and the reference power line GNDA can be avoided, thereby eliminating the risk of short circuits between the light-emitting element pad group LEDPAD and the reference power line GNDA, and improving the yield of the light-emitting substrate.

In an embodiment of the present disclosure, some of the light area connection lines LEDL are arranged in the reference power line avoidance gap GNDAG. This can reduce the risk of short circuits between the reference power line GNDA and the light area connection line LEDL, and improve the yield of the light-emitting substrate. It is noted that as shown in FIGS. 4 to 6, some of the light area connection lines LEDL need to overlap with the reference power line GNDA, so that the light area connection line LEDL passes through the wiring area of the reference power line GNDA for electrical connections with the light area power line VLEDA through a via hole. Illustratively, in the light area AA, both sides of the main reference power line GNDA are retracted to form a wiring space that acts as part of the reference power line avoidance gap GNDAG. The wiring space extends along the column direction H2. At least some of the light area connection lines LEDL extending along the column direction H2 are arranged in the wiring space.

For example, referring to FIGS. 4 to 6, the main reference power line GNDA may include a control section in the control area BB and a connection section located between the control areas BB. The reference power line avoidance gap GNDAG is arranged in the control section of the main reference power line GNDA, which is not only provided with a recessed portion, but is also smaller in width than the connection section of the main reference power line GNDA. The recessed portion and the contracted portion provided in the control section of the main reference power line GNDA compared to the connection section of the main reference power line GNDA may be used as the reference power line avoidance gap GNDAG. Along the column direction H2, the light area connection line LEDL is provided between the connection sections of the main reference power line GNDA.

It is noted that in other embodiments of the present disclosure, the main reference power line GNDA may not be provided with a reference power line avoidance gap, and part of the light-emitting element pad group LEDPAD and part of the light area connection line LEDL may overlap with the reference power line GNDA. In this way, the influences on the impedance caused by providing the reference power line GNDA with the reference power line avoidance gap GNDAG can be avoided.

In some embodiments of the present disclosure, referring to FIGS. 7 to 8, the wiring metal layer Cu2 is provided with the reference power connection line GNDL, and the reference power connection line GNDL is connected to each reference power line GNDA through a via hole HH. In other words, the reference power connection line GNDL may be disposed on the side of the chip pad group ICPAD close to the reference power pad GNDP, both ends in the row direction H1 are electrically connected to the main reference power line GNDA respectively, and the middle part is electrically connected to the auxiliary reference power line GNDA through the via hole H and is further electrically connected to the reference power pad GNDP. In this way, the reference power connection line GNDL not only electrically connects the main reference power line GNDA and the auxiliary reference power line GNDA, improving the stability of the signal on the reference power line GNDA, but also effectively provides the reference power supply voltage GND to the chip IC.

It is noted that in other embodiments of the present disclosure, the relative position between the chip pad group ICPAD and the driving line may also be in other ways.

For example, in other embodiments of the present disclosure, referring to FIG. 14, in a signal channel CH, the driving lines include the light area power line VLEDA (not shown in FIG. 14), the main reference power line GNDA, the chip power line VCCA, the address configuration line DSA, the auxiliary reference power line GNDA, the clock signal line CLKA, the auxiliary reference power line GNDA, the driving data line DataA, the address configuration line DSA, the main reference power line GNDA, and the light area power line VLEDA (not shown in FIG. 14) that are arranged sequentially along the preset direction H 11. The first column of pins of the chip pad group ICPAD is located between the address configuration line DSA and the clock signal line CLKA, such as overlapping with the auxiliary reference power line GNDA between the two driving lines. The second column of pins of the chip pad group ICPAD overlaps with the clock signal line CLKA. In an embodiment, the two address configuration lines DSA located on both sides may bridged through the address configuration transfer structure DSC (not shown in FIG. 14) located on the wiring metal layer Cu2, so that the two address configuration lines DSA located on both sides T are electrically connected as a whole.

In one example, referring to FIG. 14, the chip power line VCCA may not be provided with a chip power line avoidance gap VCCAG to avoid the chip pad group ICPAD or other driving lines, thereby ensuring that the voltage drop on the chip power line VCCA is small.

In an example, referring to FIG. 14, the width of the chip power line VCCA is smaller than the width of the main reference power line GNDA, and larger than the width of the auxiliary reference power line GNDA. The widths of the driving lines such as the address configuration line DSA, the driving data line DataA, and the clock signal line CLKA are the same, and smaller than the width of the auxiliary reference power line GNDA.

In an example, referring to FIG. 14, the reference power connection line GNDL may be electrically connected to each main reference power line GNDA, each auxiliary reference power line GNDA, and the reference power pad GNDP.

As another example, in some other embodiments of the present disclosure, referring to FIG. 15, in a signal channel CH, the driving lines include light area power line VLEDA (not shown in FIG. 15), main reference power line GNDA, chip power line VCCA, address configuration line DSA, clock signal line CLKA, auxiliary reference power line GNDA, driving data line DataA, address configuration transfer structure DSC, main reference power line GNDA, light area power line VLEDA (not shown in FIG. 15) that are arranged sequentially along the preset direction H11. The width of the auxiliary reference power line GNDA is not less than the width of the chip pad group ICPAD. In this way, the chip pad group ICPAD can be disposed on the auxiliary reference power line GNDA, or disposed in the avoidance space formed by disconnecting the auxiliary reference power line GNDA.

In one example, referring to FIG. 15, the auxiliary reference power line GNDA is disconnected at the chip pad group ICPAD to form an avoidance space as the chip area ICA where the chip pad group ICPAD is arranged, and the chip pad group ICPAD is disposed within the chip area ICA. In this way, wirings of the address configuration line DSA, the clock signal line CLKA, the driving data line DataA, and the address configuration transfer structure DSC do not need to be bent to avoid the chip pad group ICPAD. The auxiliary reference power line GNDA is divided into multiple sections by the avoidance space. Further, one end of the auxiliary reference power line GNDA close to the chip pad group ICPAD is electrically connected to the reference power connection line GNDL. In this way, the reference power connection line GNDL includes a first reference power connection line GNDL 1 and a second reference power connection line GNDL2. The first reference power connection line GNDL1 and the second reference power connection line GNDL2 are respectively connected with ends of the two auxiliary reference power lines GNDA close to the chip pad group ICPAD, and are both connected to the two main reference power lines GNDA.

In one example, the chip power line VCCA is provided with a chip power line avoidance gap VCCAG, and the main reference power line GNDA has a reference power line extension GNDE extending to one side of the chip pad group ICPAD. Part of the reference power line extension GNDE may be located in the chip power line avoidance gap VCCAG. In this way, the reference power connection line GNDL can be connected to the reference power line extension GNDE through the via hole HH, and the light area connection line LEDL can be avoided.

In one example, part or all of the chip power line avoidance gaps VCCAG may be disconnected so that the chip power line VCCA is divided into multiple sections. Two adjacent sections of the chip power line VCCA may be electrically connected by a chip power transfer structure VCCBC provided on the wiring metal layer Cu2.

In one example, the chip power connection line VCCL is connected to the chip power transfer structure VCCBC.

In one example, the chip power transfer structure VCCBC includes two lines side by side to avoid a defective ground structure.

In one example, the front address configuration line DSA corresponding to the chip pad group ICPAD is electrically connected to the address configuration pad DISP through the address configuration connection line DISL. The rear address configuration line DSA corresponding to the chip pad group ICPAD is electrically connected to the address configuration transfer structure DSC through a transfer line located on the wiring metal layer Cu2. The address configuration transfer structure DSC is electrically connected to the address relay pad DOSP through the address relay connection line DOSL.

In one example, the address configuration line DSA, CKLA, the driving data line DataA, and the address configuration transfer structure DSC have the same width which is smaller than that of the auxiliary reference power line GNDA. The width of the chip power line VCCA is larger than that of the auxiliary reference power line GNDA and smaller than that of the main reference power line GNDA (all of the main reference power lines GNDA are not shown in FIG. 15).

In one example, a gap for laying out the light area connection line LEDL is provided between the chip power line VCCA and the main reference power line GNDA, so as to reduce the overlap between the light area connection line LEDL and the main reference power line GNDA and reduce the risk of undesirable short circuits.

In some embodiments, the wiring metal layer Cu2 is also provided with multiple resistance-reducing structures (such as the light area power resistance-reducing structure VLEDB, the reference power resistance-reducing structure GNDB, the chip power resistance-reducing structure VCCB, etc. in FIGS. 6 and 7), where any resistance-reducing structure is arranged correspondingly to one of the driving lines. The resistance-reducing structure is connected to the corresponding driving line through the via hole HH. It can be understood that any driving line may correspond to one or more resistance-reducing structures, and that multiple resistance-reducing structures may correspond to the same driving line. In this way, the driving line connected to the resistance-reducing structure through the via hole is equivalent to being connected with a conductive path in parallel, so that the impedance of the driving line is reduced. On the one hand, this can reduce the impedance of the driving line and ensure that signals and power supply have smaller voltage drops on the light-emitting substrate. On the other hand, it can reduce the thickness or width of the driving line.

In one embodiment of the present disclosure, the driving metal layer Cu1 with a smaller thickness may be formed by a magnetron sputtering method. Since the resistance-reducing structure of the wiring metal layer Cu2 can reduce the impedance of the driving line, the reduction in the thickness of the driving metal layer Cu1 will not have a significant negative impact on the electrical performance of the light-emitting substrate, and the preparation process of the driving metal layer Cu1 can be simplified and the cost and the thickness of the light-emitting substrate is reduced. In an embodiment of the present disclosure, the orthographic projection of the resistance-reducing structure on the base substrate BP is located within the orthographic projection of the corresponding driving line on the base substrate BP.

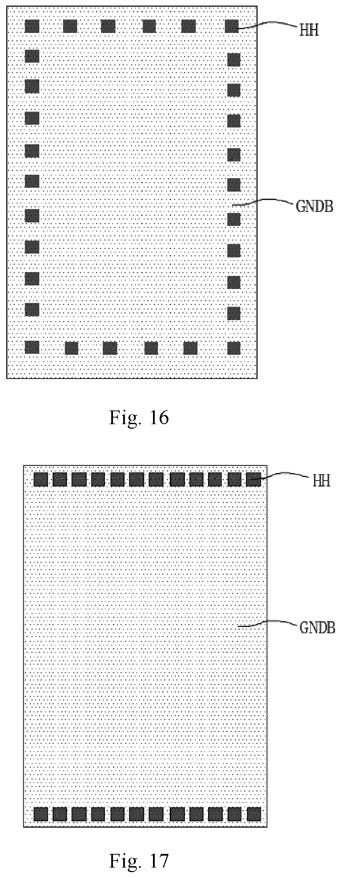

Optionally, the resistance-reducing structure and the corresponding driving line may be connected through a via hole, especially through multiple via holes HH. In FIGS. 16 to 20, the reference power resistance-reducing structure GNDB corresponding to the main reference power line GNDA is taken as an example for illustrating the arrangement of the via holes HH between the resistance-reducing structure and the corresponding driving line. It can be understood that the example arrangement patterns of via holes HH in FIGS. 16 to 20 are only examples of some embodiments of the present disclosure.

In one embodiment of the present disclosure, referring to FIG. 16, the via holes HH on the resistance-reducing structure (the reference power resistance-reducing structure GNDB is used as an example in FIG. 16) may be arranged in an annular shape around the edge of the resistance-reducing structure. It is noted that when the width of the resistance-reducing structure is too small to form an annular shape, the arrangement may be also along the column direction H2. This arrangement of via holes HH can, on the one hand, provides a dispersed and multipoint connection between the resistance-reducing structure and the corresponding driving line, thereby improving diversity and flexibility of the current between the resistance-reducing structure and the driving line. Thus, a lower contact impedance is provided between the resistance-reducing structure and the corresponding driving line, the heating problem caused by the via hole contact impedance is reduced, and the reliability of the light-emitting substrate is improved. On the other hand, there is a small contact area between the resistance-reducing structure and the corresponding driving line, which can ensure that the area of the first insulation layer OC1 between the resistance-reducing structure and the driving line will not be excessively reduced, thereby avoiding the capacitance value to increase due to the reduction in the area of the first insulation layer OC1.

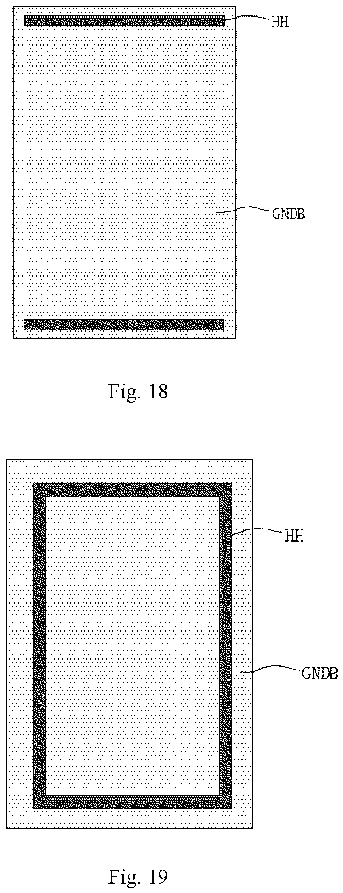

It is noted that in other examples of the present disclosure, the via holes HH between the resistance-reducing structure and the corresponding driving line are also arranged in other possible ways. In an example, see FIG. 17 (using the reference power resistance-reducing structure GNDB for illustrating the resistance-reducing structure), the via holes HH may be arranged into multiple rows of via holes, for example, arranged into two rows of via holes located at both ends of the resistance-reducing structure in the column direction H2. Each row of via holes includes a plurality of via holes H extending along the row direction H1. In another example, see FIG. 18 (using the reference power resistance-reducing structure GNDB for illustrating the resistance-reducing structure), the via holes in the row of via holes may be merged into one via hole HH, so that the via hole HH is a long strip hole extending in the row direction H1. In another example, see FIG. 19 (using the reference power resistance-reducing structure GNDB for illustrating the resistance-reducing structure), the via holes surrounding the edge of the resistance-reducing structure may be merged in sequence to form an entire annular via hole HH. In another example, see FIG. 20 (using the reference power resistance-reducing structure GNDB for illustrating the resistance-reducing structure), the part of the first insulation layer OC1 surrounded by the annular via hole is also removed, so that the via hole HH forms an entire cavity structure, and the edge of the cavity structure is arranged along the edge of the resistance-reducing structure. In this way, the resistance-reducing structure located in the wiring metal layer Cu2 directly overlaps with the driving line located in the driving metal layer Cu1 in a large area. For example, the overlapping area is more than 30% of the area of the resistance-reducing structure.

In an embodiment of the present disclosure, the size of the via hole HH between the resistance-reducing structure and the corresponding driving line may be between 100 and 300 microns. For example, the size of the via hole between the resistance-reducing structure and the corresponding driving line is 200 microns.

In an embodiment of the present disclosure, the spacing of the via holes HH between the resistance-reducing structure and the corresponding driving line may be between 800 and 1200 microns. For example, the spacing of the via holes between the resistance-reducing structure and the corresponding driving line may be 1000 microns.

In an embodiment of the present disclosure, between the resistance-reducing structure and the corresponding driving line, the distance between the via hole HH and the edge of the resistance-reducing structure is not less than 10 microns.

In an embodiment of the present disclosure, the shape of the via hole HH between the resistance-reducing structure and the corresponding driving line may be square or circular. It is noted that the shape of the via hole HH may also be other feasible shapes, such as rectangle, hexagon, etc.

In an embodiment of the present disclosure, referring to FIGS. 4 to 8, the resistance-reducing structure includes a reference power resistance-reducing structure GNDB corresponding to the main reference power line GNDA, and the orthographic projection of the reference power resistance-reducing structure GNDB on the base substrate BP is located in the corresponding main reference power line GNDA. The reference power resistance-reducing structure GNDB is connected to the corresponding reference power line GNDA through a via hole. In an embodiment, at least some of the via holes between the reference power line GNDA and the reference power resistance-reducing structure GNDB may be arranged around the edge of the reference power resistance-reducing structure GNDB to efficiently reduce the impedance of the reference power line GNDA. It is noted that in another embodiment of the present disclosure, the via holes located between the reference power line GNDA and the reference power resistance-reducing structure GNDB may be arranged into two rows, and each row includes a plurality of via holes arranged along the row direction H1. The two rows of via holes may be respectively disposed at both ends of the reference power resistance-reducing structure GNDB in the column direction H2. In another embodiment of the present disclosure, the via holes in the row may be connected in sequence to form a long strip hole extending along the row direction H1 as a whole.

In an embodiment of the present disclosure, the reference power line GNDA may include a control section in the control area BB and a connection section between the control areas BB.

In an embodiment of the present disclosure, the reference power resistance-reducing structure GNDB may include: a connection section of the reference power resistance-reducing structure GNDB overlapping with the connection section of the reference power line GNDA, and a control section of the reference power resistance-reducing structure GNDB overlapping with the control section of the reference power line GNDA. Referring to FIGS. 6 and 7, a light area connection line LEDL is provided between the connection section of the reference power resistance-reducing structure GNDB and the control section of the reference power resistance-reducing structure GNDB.

In an embodiment of the present disclosure, the control section of the reference power resistance-reducing structure GNDB is provided with an avoidance gap that exposes the control section of the reference power line GNDA. The reference power connection line GNDL is electrically connected to the reference power line GNDA in the avoidance gap through the via hole.

In an embodiment of the present disclosure, the reference power resistance-reducing structure GNDB corresponding to the auxiliary reference power line GNDA may not be provided on the auxiliary reference power line GNDA.

In some embodiments of the present disclosure, referring to FIGS. 4 to 8, the resistance-reducing structure may include a light area power resistance-reducing structure VLEDB corresponding to the light area power line VLEDA. The orthographic projection of the light area power resistance-reducing structure VLEDB on the base substrate BP is located in the corresponding light area power line VLEDA, and is electrically connected to the light area power line VLEDA through a plurality of via holes HH. In an embodiment, at least some of the via holes HH located between the light area power line VLEDA and the light area power resistance-reducing structure VLEDB may be arranged around the edge of the light area power resistance-reducing structure VLEDB to efficiently reduce the impedance of the light area power line VLEDA. In an embodiment of the present disclosure, in each control area BB, one or more via holes HH, that are not located at the edge of the light area power resistance-reducing structure VLEDB, may be provided between the light area power line VLEDA and the light area power resistance-reducing structure VLEDB, so that these via holes and some of the via holes located at the edge form a row of via holes, thereby increasing the via hole density and thereby reducing the impedance of the light area power line VLEDA.

It is noted that in another embodiment of the present disclosure, the via holes located between the light area power line VLEDA and the light area power resistance-reducing structure VLEDB may be arranged into two rows of via holes, and each row includes multiple via holes arranged along the row direction H1. The two rows of via holes may be respectively disposed at both ends of the light area power resistance-reducing structure VLEDB in the column direction H2. In another embodiment of the present disclosure, the via holes in the row may be connected in sequence to form a long strip hole extending along the row direction H1 as a whole.

In an embodiment of the present disclosure, in the non-fan-out area, the light area power resistance-reducing structure VLEDB may completely overlap with the light area power line VLEDA, so that the light area power resistance-reducing structure VLEDB has the largest layout area and can reduce the impedance of the light area power line VLEDA to the greatest extent.

In some embodiments, referring to FIGS. 4 to 8, the resistance-reducing structure may include a chip power resistance-reducing structure VCCB. The orthographic projection of the chip power resistance-reducing structure VCCB on the base substrate BP is located within the chip power line VCCA, and the chip power resistance-reducing structure VCCB is electrically connected to the chip power line VCCA through multiple via holes. In an embodiment of the present disclosure, the chip power resistance-reducing structure VCCB may overlap with the avoidance section of the chip power line VCCA, but not overlap with the non-avoidance section of the chip power line VCCA. In this way, an avoidance space is formed between adjacent chip power resistance-reducing structures VCCB, so that connection lines including the clock signal connection line CLKL, the light area connection line LEDL, the address configuration connection line DISL, the chip power connection line VCCL, and the reference power connection line GNDL, etc. can be arranged on the wiring metal layer Cu2.

In an embodiment of the present disclosure, referring to FIG. 7, the chip power resistance-reducing structure VCCB and the chip power line VCCA are connected through a plurality of via holes arranged sequentially along the column direction H2.

In some embodiments of the present disclosure, the device layer may also be provided with a capacitor, and the two pins of the capacitor are electrically connected to the reference power line GNDA and other power lines (power lines other than the reference power line GNDA) respectively. This stabilizes the signal on the power line, filters out the noise on the power line, and decouples the power line from the reference power line GNDA, thereby avoiding voltage fluctuations on the power line that would degrade the quality of the light-emitting substrate.

Optionally, the capacitor may be disposed outside the light area AA to reduce the impact on the light output uniformity of the light-emitting substrate and reduce the wiring difficulty.

Optionally, the capacitors may be arranged evenly on the light-emitting substrate, to eliminate possible fluctuations in the voltage signal more efficiently and uniformly, and to have a more uniform impact on the light output uniformity of the light-emitting substrate.

Optionally, the capacitors may be provided on only some power lines to avoid setting capacitors on each power line, which would cause the density of capacitors too high, thereby preventing the density of capacitors from being too high and affecting the light output uniformity of the light-emitting substrate.

In an embodiment of the present disclosure, referring to FIG. 3, a first capacitor Cst1 may be provided between at least some of the light area power lines VLEDA and the reference power lines GNDA, so that the noise on the light area power line VLEDA is filtered out, thereby improving the stability of the light area power supply voltage VLED on the light area power line VLEDA.

In one example, the wiring metal layer Cu2 may be provided with a first capacitor pad group. The first capacitor pad group includes: a first pad for first capacitor connected to the light area power line VLEDA through a via hole, and a second pad for first capacitor connected to the main reference power line GNDA through a via hole. The two pins of the capacitor are electrically connected to the first pad for first capacitor and the second pad for first capacitor respectively.

In one example, capacitors may be connected to some of the light area power lines VLEDA, and no capacitors may be connected to the remaining light area power lines VLEDA, so as to avoid too many capacitors from affecting the light output uniformity of the light-emitting substrate.

In one example, two adjacent light area power lines VLEDA of two adjacent signal channels CH are electrically connected to each other to form a merged light area power line VLEDA. For example, they are merged into a wider line, or mutually connected through a conductive structure to form a hollow structure. A first capacitor is connected between any merged light area power line VLEDA and the reference power line GNDA. Further, 3 to 5 first capacitors are connected to each merged light area power line VLEDA.

For example, in an embodiment of the present disclosure, on the light-emitting substrate, the number of columns of light areas AA is 80 columns, and the number of rows of light areas AA is 45 rows (one end away from the bonding pad, one chip IC can drive two light areas AA). The first capacitor Cst1 is provided on the light area power line VLEDA that drives the even-numbered column or the odd-numbered column. The first capacitors Cst1 are arranged in four rows, and each row of first capacitors Cst1 is adjacent to the 11th row (starting from the end close to the bonding pad), the 13th row, the 33rd row, and the 39th row of light areas AA.

In an embodiment of the present disclosure, referring to FIG. 3, a second capacitor Cst2 may be provided between at least some of the chip power lines VCCA and the main reference power lines GNDA, so that the noise on the chip power line VCCA is filtered out. This further improves the stability of the chip power supply voltage VCC on the chip power line VCCA.

In one example, the wiring metal layer Cu2 may be provided with a second capacitor pad group. The second capacitor pad group includes: a first pad for the second capacitor connected to the chip power line VCCA through a via hole, and a second pad for the second capacitor connected to the main reference power line GNDA through a via hole. The two pins of the capacitor are electrically connected to the first pad for the second capacitor and the second pad for the second capacitor respectively.

In one example, the second capacitor Cst2 may be connected to some of the chip power lines VCCA, and the second capacitor Cst2 may not be connected to the remaining chip power lines VCCA, so as to avoid too many second capacitors Cst2 from affecting the light output uniformity of the light-emitting substrate.

In one example, a second capacitor Cst2 is connected to each chip power line VCCA. Further, the number of second capacitors Cst2 connected to each chip power line VCCA is 2 to 4.

For example, in an embodiment of the present disclosure, on the light-emitting substrate, the number of columns of light areas AA is 80 columns, and the number of rows of light areas AA is 45 rows (one end away from the bonding pad, one chip IC can drive two light areas AA). Three second capacitors Cst2 are connected to each chip power line VCCA. The second capacitors Cst2 are arranged in three rows, and the row of second capacitors Cst2 is adjacent to the 3rd row (starting from the end close to the bonding pad), the 23rd row, and the 43rd row of light areas AA.

In an embodiment of the present disclosure, the electronic components may further include: a temperature sensor for measuring temperature, and a third capacitor for filtering a power line of the temperature sensor. On the driving metal layer Cu1, the driving lines include a temperature sensor power line used to load the temperature sensor power supply voltage to the temperature sensor. One pin of the third capacitor is electrically connected to the temperature sensor power line, and the other pin is electrically connected to the main reference power line GNDA.

In one example, a third capacitor is connected to each temperature sensor power line.

In one example, 2 to 4 third capacitors are connected to each temperature sensor power line.

In one example, the wiring metal layer Cu2 is provided with a third capacitor pad group, a first temperature sensor wiring, a second temperature sensor wiring, and a temperature sensor pad group for bonding the temperature sensor. The first temperature sensor wiring is electrically connected to the temperature sensor power line and to the temperature sensor pad group, for loading the temperature sensor power supply voltage to the temperature sensor. The second temperature sensor wiring is electrically connected to the reference power line GNDA and to the temperature sensor pad group, for loading the reference power supply voltage GND to the temperature sensor. The third capacitor pad group includes a first pad for the third capacitor and a second pad for the third capacitor. The first pad for the third capacitor is arranged on the first temperature sensor wiring, and the second pad for the third capacitor is arranged on the second temperature sensor wiring. The two pins of the third capacitor are electrically connected to the first pad of the third capacitor and the second pad of the third capacitor respectively.

For example, in an embodiment of the present disclosure, on the light-emitting substrate, the number of columns of light areas AA is 80 columns, and the number of rows of light areas AA is 45 rows (one end away from the bonding pad, one chip IC can drive two light areas AA). The light-emitting substrate is provided with at least 5 columns of temperature sensor power lines, and the 5 columns of temperature sensor power lines are adjacent to the 8th, 24th, 40th, 56th, and 72nd column of light areas respectively. Each column of temperature sensor power lines includes three temperature sensor power lines, and each temperature sensor power line is connected to a third capacitor. The third capacitors are arranged in three rows and five columns. Along the column direction H2, the row of third capacitors is adjacent to the 6th row (starting from the end close to the bonding pad), the 22nd row, and the 38th row of light areas AA. Along the row direction H1, the third capacitors are adjacent to the 8th, 24th, 40th, 56th, and 72nd columns of light areas.

In some embodiments of the present disclosure, referring to FIG. 9, the main reference power lines GNDA may be merged with each other to form a main reference power line GNDA with a larger width. In this way, the light-emitting substrate may be provided with only one main reference power line GNDA in one signal channel CH. In an embodiment of the present disclosure, the main reference power line GNDA is provided on a side of the chip power line VCCA away from the driving data line DataA. In an embodiment of the present disclosure, the chip pad group ICPAD is located on one side of the main reference power line GNDA, without overlapping the main reference power line GNDA. This causes the chip pad group ICPAD to deviate from the center of the signal channel CH in the row direction. In an embodiment of the present disclosure, the chip pad group ICPAD is located between the main reference power line GNDA and the auxiliary reference power line GNDA.

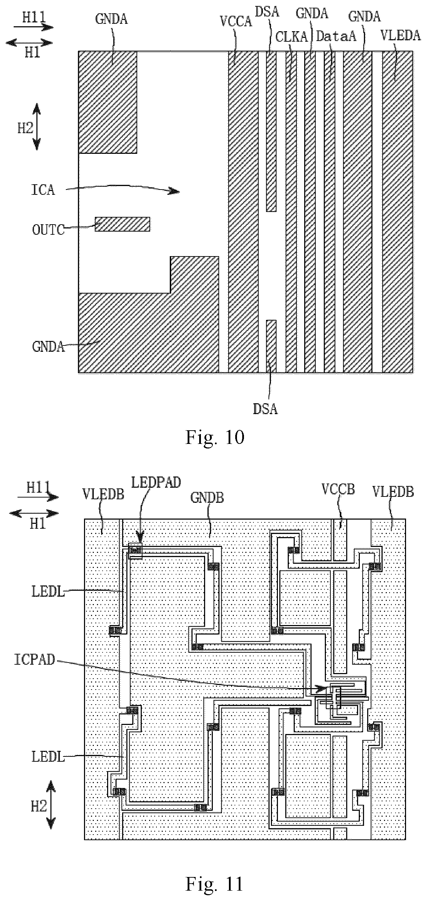

In one example, referring to FIGS. 9 and 10, along the preset direction H11, the driving lines in one signal channel CH may include the light area power line VLEDA, the main reference power line GNDA, the chip power line VCCA, the address configuration line DSA, the clock signal line CLKA, the auxiliary reference power line GNDA, the driving data line DataA, the auxiliary reference power line GNDA, and the light area power line VLEDA that are arranged in sequence. In an example, an auxiliary reference power line GNDA is provided between the clock signal line CLKA and the driving data line DataA, thereby preventing signals on the driving data line DataA from causing crosstalk to the clock signal line CLKA.

In an example, see FIGS. 11 to 13, the light area connection line LEDL for the light area power supply voltage V, the light-emitting element pad group LEDPAD, etc., set on the wiring metal layer Cu2, may be overlapped with the light area power line VLEDA, the reference power line GNDA etc.

In one example, the wiring metal layer Cu2 is provided with a light area power resistance-reducing structure VLEDB that overlaps with the light area power line VLEDA. The light area power resistance-reducing structure VLEDB and the light area power line VLEDA are connected through multiple via holes. The via holes are arranged at least partially around the edge of the light area power resistance-reducing structure VLEDB.

In one example, the wiring metal layer Cu2 is provided with a reference power resistance-reducing structure GNDB that partially overlaps the main reference power line GNDA, and the light area connection line LEDL for the light area power supply voltage V and the light-emitting element pad group LEDPAD, etc. are arranged between the reference power resistance-reducing structures GNDB. The reference power resistance-reducing structure GNDB and the reference power line GNDA are connected through a plurality of via holes. The plurality of via holes is at least partially arranged around the edge of the reference power resistance-reducing structure GNDB.

In one example, the chip pad group ICPAD is disposed between the chip power line VCCA and the main reference power line GNDA. The driving metal layer Cu1 is provided with an output transfer line OUTC between the main reference power line GNDA and the chip pad group ICPAD. The light area connection lines LEDL for the light area power supply voltage V connected to the third output pad OUT3P bridged through the output transfer line OUTC.

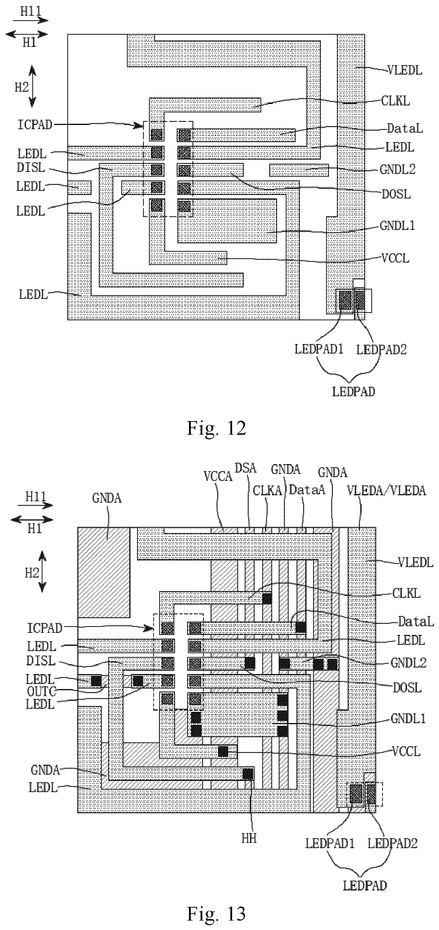

In one example, referring to FIG. 13, the clock signal connection line CLKL overlaps the chip power line VCCA, the address configuration line DSA, and the clock signal line CLKA, and is electrically connected to the clock signal pad CLKP and the clock signal line CLKA.

The driving data connection line DataL overlaps with the chip power line VCCA, the address configuration line DSA, the clock signal line CLKA, the auxiliary reference power line GNDA, and the driving data line DataA, and is connected to the driving data pad DataP and the driving data line DataA.

The address configuration connection line DISL overlaps the output transfer line OUTC, the main reference power line GNDA, the chip power line VCCA, and the front address configuration line DSA, and is connected to the address configuration pad DISP and the front address configuration line DSA.

The address relay connection line DOSL overlaps the chip power line VCCA and the rear address configuration line DSA, and is connected to the chip power pad VCCP and the rear address configuration line DSA.

The reference power connection line GNDL includes a first reference power connection line GNDL1 and a second reference power connection line GNDL2. The main reference power supply voltage GND has a reference power line extension GNDE extending to the side close to the reference power pad GNDP. The first reference power connection line GNDL1 is connected to the reference power line extension GNDE, the reference power pad GNDP and the auxiliary reference power line GNDA of the chip power line VCCA. The second reference power connection line GNDL2 is connected to two auxiliary reference power lines GNDA.

In one example, the chip power line VCCA is provided with a chip power line avoidance gap VCCAG to avoid the chip pad group ICPAD on a side close to the main reference power line GNDA. The chip pad group ICPAD is arranged in the chip power line avoidance gap VCCAG. The chip power line VCCA has an avoidance section with a chip power line avoidance gap VCCAG and a non-avoidance section without a chip power line avoidance gap VCCAG. The width of the avoidance section of the chip power line VCCA is smaller than the width of the non-avoidance section of the chip power line VCCA.

In one example, the wiring metal layer Cu2 is also provided with a chip power resistance-reducing structure VCCB, and the chip power resistance-reducing structure VCCB is connected to the non-avoidance section of the chip power line VCCA through a via hole.

In the light-emitting substrate of the present disclosure, the wiring arrangement in local areas can be fine-tuned according to actual wiring requirements. For example, when a line located on the driving metal layer Cu1 is blocked by other lines on the driving metal layer Cu1, the line may be bridged through the wiring metal layer Cu2. Accordingly, when a line located on the wiring metal layer Cu2 is blocked by other lines on the wiring metal layer Cu2, the line may be bridged through the driving metal layer Cu1. In some embodiments, in the fan-out area of the PNL, the fan-out lines are provided on the driving metal layer Cu1. When the fan-out lines are blocked by other driving lines, the fan-out lines may be partially bridged through the wiring metal layer Cu2. In other embodiments, in the fan-out area, some chip ICs need to be connected to the driving lines and the light areas through long connection lines. These connection lines may need to be bent to avoid other connection lines. Also, the bridge connection may be made through the driving metal layer Cu1 to avoid other lines.

In the display device provided by the present disclosure, the light-emitting substrate may directly display a picture as a display panel, or may be used as a backlight source of a transmissive liquid crystal display device or as a frontlight source of a reflective liquid crystal display device. The display device may be a mobile phone screen, a computer monitor, a television, an electronic billboard, or other display devices, which are not specifically limited in the present disclosure.

Other embodiments of the present disclosure will be readily apparent to those skilled in the art from consideration of the specification and practice of the contents disclosed herein. This application is intended to cover any variations, uses, or adaptations of the present disclosure that follow the general principle of the present disclosure and include common knowledge or customary technical means in the technical field that are not disclosed in the present disclosure. It is intended that the specification and examples be considered as exemplary only, with the true scope and spirit of the present disclosure being indicated by the following claims.

## Claims

1. A light-emitting substrate, comprising a plurality of signal channels arranged in sequence along a row direction, wherein
each signal channel comprises a plurality of control areas arranged along a column direction, and each control area comprises at least one light area controlled by a same chip;
in each signal channel, the light-emitting substrate is provided with a first driving line, a second driving line, and a plurality of reference power lines;
the first driving line and the second driving line are respectively used for providing different driving signals to the chip; and
the reference power line is used for providing a reference power supply voltage to the chip, wherein
the reference power lines in a same signal channel are electrically connected, and at least one reference power line is provided between the first driving line and the second driving line.

2. The light-emitting substrate according to claim 1, wherein
the first driving line is a clock signal line for providing a clock signal to the chip; and
the second driving line is a driving data line for providing a driving data signal to the chip or an address configuration line for providing an address configuration signal to the chip.

3. The light-emitting substrate according to claim 1, wherein the second driving line is a driving data line.

4. The light-emitting substrate according to claim 3, wherein
in the signal channel, the light-emitting substrate further comprises: a light area power line for loading a light area power supply voltage to the light area, a chip power line for loading a chip power supply voltage to the chip, and an address configuration line for loading an address configuration signal to the chip; and
along the row direction, the light area power line, the reference power line, the chip power line, the address configuration line, the clock signal line, the reference power line, the driving data line, the reference power line, and the light area power line are arranged in sequence.

5. The light-emitting substrate according to claim 4, wherein
the reference power line is further provided between the address configuration line and the clock signal line.

6. The light-emitting substrate according to claim 3, wherein
the light-emitting substrate has a chip pad group for bonding and connecting with the chip, and is provided with a reference power connection line; and
the reference power connection line is connected to each reference power line through a via hole, and is electrically connected to the chip pad group.

7. The light-emitting substrate according to claim 3, wherein
in the signal channel, the plurality of reference power lines comprise: two main reference power lines located on both sides of the signal channel, and an auxiliary reference power line located between the main reference power lines;
a width of the main reference power line is greater than a width of the auxiliary reference power line; and
the main reference power line overlaps the light areas, and does not overlap at least some of the chips.

8. The light-emitting substrate according to claim 3, wherein
in the signal channel, the plurality of reference power lines comprise a main reference power line and at least one auxiliary reference power line; and
the main reference power line has a largest width among the reference power lines, and is not adjacent to the driving data line and the clock signal line.

9. The light-emitting substrate according to claim 8, wherein
the chip is located between the main reference power line and the auxiliary reference power line.

10. The light-emitting substrate according to claim 7 or 8, wherein
in the signal channel, the light-emitting substrate further comprises: a light area power line for loading a light area power supply voltage to the light area, and a chip power line for loading a chip power supply voltage to the chip;
the main reference power line is adjacent to the light area power line, and has a width greater than that of the chip power line; and
a width of the auxiliary reference power line is smaller than that of the chip power line.

11. The light-emitting substrate according to any one of claims 1 to 9, wherein
the light-emitting substrate further comprises: a light area power line for loading a light area power supply voltage to the light area, and a chip power line for loading a chip power supply voltage to the chip;
a first capacitor is provided between at least some of the light area power lines and the reference power lines; and/or
a second capacitor is provided between at least some of the chip power lines and the reference power lines.

12. The light-emitting substrate according to claim 11, wherein
among two adjacent signal channels along the row direction, a light area power line in one signal channel is arranged adjacently to a light area power line in the other signal channel;
the two adjacent light area power lines are connected to form a merged light area power line, and the merged light area power line is used for providing the light area power supply voltage to the light areas in the two signal channels; and
3 to 5 first capacitors are provided between any one of the merged light area power lines and the reference power lines.

13. The light-emitting substrate according to claim 11, wherein
2 to 4 second capacitors are provided between any one of the chip power lines and the reference power lines.

14. The light-emitting substrate according to any one of claims 1 to 9, wherein
the light-emitting substrate is provided with a temperature sensor, and a temperature sensor power line for loading a temperature sensor power supply voltage to the temperature sensor; and
a third capacitor is provided between any one of the temperature sensor power lines and the reference power lines.

15. The light-emitting substrate according to any one of claims 1 to 9, wherein
the light-emitting substrate comprises a base substrate, a driving metal layer, a first insulation layer, a wiring metal layer, a second insulation layer, and a device layer being stacked in sequence;
the driving metal layer is provided with the first driving line, the second driving line, and the reference power lines;
the light area comprises a plurality of electrically connected light-emitting elements, and the light-emitting elements and the chip are provided on the device layer; and
the wiring metal layer is provided with a light-emitting element pad group for bonding the light-emitting elements, a chip pad group for bonding the chip, and a connection line for electrically connecting the light-emitting element pad group and the chip pad group.

16. The light-emitting substrate according to claim 15, wherein
the wiring metal layer is provided with a reference power resistance-reducing structure corresponding to at least some of the reference power lines; and
the reference power resistance-reducing structure is connected thourgh a via hole with a respective reference power line.

17. The light-emitting substrate according to claim 16, wherein
an orthographic projection of the reference power resistance-reducing structure on the base substrate is located within an orthographic projection of the respective reference power line on the base substrate.

18. The light-emitting substrate according to claim 16, wherein
at least some of the via holes between the reference power resistance-reducing structure and the respective reference power line are arranged around an edge of the reference power resistance-reducing structure.

19. The light-emitting substrate according to claim 16, wherein
in the signal channel, the plurality of reference power lines have one or two main reference power lines with a largest width, and the reference power resistance-reducing structure and the main reference power line are connected.

20. The light-emitting substrate according to claim 15, wherein
the driving metal layer is provided with a light area power line for loading a light area power supply voltage to the light area;
the wiring metal layer is provided with a light area power resistance-reducing structure corresponding to the light area power line; and
the light area power line and the respective light area power resistance-reducing structure are connected through a via hole.

21. The light-emitting substrate according to claim 20, wherein
at least some of the via holes between the light area power resistance-reducing structure and the respective light area power line are arranged around an edge of the light area power resistance-reducing structure.

22. The light-emitting substrate according to claim 20, wherein
an orthographic projection of the light area power resistance-reducing structure on the base substrate coincides with an orthographic projection of the respective light area power line on the base substrate.

23. The light-emitting substrate according to claim 15, wherein
the driving metal layer is provided with a chip power line for loading a chip power supply voltage to the chip;
the wiring metal layer is provided with a chip power resistance-reducing structure corresponding to the chip power line; and
the chip power resistance-reducing structure and the respective chip power line are connected through a via hole.

24. The light-emitting substrate according to claim 23, wherein
at least some of the via holes between the chip power resistance-reducing structure and the respective chip power line are arranged in a line along the column direction.

25. A display device, comprising the light-emitting substrate according to any one of claims 1 to 24.
